Europäisches Patentamt

(19) European Patent Office

Office européen des brevets

(11) Publication number: **0 220 043 B1**

## (12) EUROPEAN PATENT SPECIFICATION

(45) Date of publication of patent specification: **07.04.93**  (51) Int. Cl.⁵: **H03H  11/24**, H03G 1/00, H03G 7/00, H03G 9/18

(21) Application number: **86307906.7**

(22) Date of filing: **13.10.86**

(54) **Circuits to provide desired conductance characteristics using a fet.**

(30) Priority: **15.10.85 US 787637**
**03.03.86 US 835243**
**03.03.86 US 835245**
**07.10.86 US 914481**

(43) Date of publication of application:
**29.04.87 Bulletin  87/18**

(45) Publication of the grant of the patent:
**07.04.93 Bulletin  93/14**

(84) Designated Contracting States:
**BE CH DE FR GB IT LI NL SE**

(56) References cited:
**EP-A- 0 003 509**

**IEEE TRANSACTIONS ON CIRCUITS AND SYSTEMS, vol. CAS-30, no. 10, October 1983, pages 770-772, IEEE, New York, US; K. NAY et al.: "Circuits and systems letters"**

(73) Proprietor: **Dolby, Ray Milton**
**3340 Jackson Street**
**San Francisco California 94118(US)**

(72) Inventor: **Dolby, Ray Milton**
**3340 Jackson Street**
**San Francisco California 94118(US)**

(74) Representative: **Pears, David Ashley et al**
**REDDIE & GROSE 16 Theobalds Road**
**London WC1X 8PL (GB)**

## Description

Background of the Invention.

This invention relates to circuits for providing a desired resistance (or conductance) characteristic using a field effect transistor (FET). The circuits described are particularly suitable for use as attenuator circuits employing an impedance as well as the FET, the FET providing a conductance as a desired predetermined function of a control signal, in order to provide a standardised gain control or frequency response characteristic.

Three-terminal field effect transistors have been used frequently to provide variable conductances where the conductances between the source and drain are controlled by a control signal applied to the gate of the FET. The drain-source conductances of most FETs vary linearly with the control voltage applied across the source and gate so that incremental changes in the control voltage will cause proportional incremental changes in their conductances. The variation of the drain-source conductance of a FET as a function of the control signal is known as the conductance control characteristic of the FET.

Field effect transistors used as variable conductances have been employed in signal attenuators. For example, they have been used in limiters for noise reduction systems where compressors and expanders require controlled limiting of the amplitude of a signal. In U.S Patent 4,490,691, a field effect transistor is used in conjunction with a capacitor to form a high pass filter with a sliding band type high frequency shelf response whose corner frequency varies as a function of the control signal to the gate of the transistor. In this particular high pass filter circuit the drain-source path of the FET shunts the signal to be limited to ground. In other attenuator or limiter circuits, the drain-source conductance of the FET may be placed in the series path of the signal instead of in a shunt path. A FET can be used in conjunction with an inductor to form a sliding band circuit with a low frequency band pass response operating downwardly. A FET may also be used in conjunction with a resistor and another filter to form a fixed band attenuator circuit whose frequency range does not change, in contrast to the sliding band filter circuits. In each of the above types of attenuators, the characteristics of the attenuator are varied by varying the conductance of the drain-source path of the FET.

In many attenuator, limiter and filter circuits it is important for the circuits to have precise and reproducible characteristics. For noise reduction systems employing complementary compressors and expanders, for example, it is important for the signal limiters and filters in a group of matching compressors (or expanders) to have similar characteristics. This enables the original uncompressed signal to be recovered by any expander complementary to the group of compressors from a compressed signal compressed by a compressor in the group, and enables the use of any matching compressor to produce the compressed signal.

In order that the signal attenuators, limiters or sliding band circuits in the compressors (or expanders) have similar signal attenuating characteristics, it is desirable for the FETs in such circuits to have similar conductance control characteristics. In other words, the conductances of the FETs in the different limiter circuits in the compressors (or expanders) are preferably the same in response to the same control signals. It is well known that the conductance control characteristics of FETs vary widely, so that different FETs may have very different conductances even though the same control signal is applied to their gates. It is therefore desirable to select or fabricate FETs or otherwise provide FET circuits which will have the same conductance in response to the same control signal.

Until now, the favorite method for providing FETs having the same conductance control characteristic is to use special manufacturing processes which may be expensive and difficult. Simpler and less expensive methods are thus desirable. In a method employed by Dolby Laboratories of San Francisco, California to provide reproducible FET conductance control characteristics, the FETs used are selected so that a control signal fed to their gates will produce essentially the same conductances. Then, offset voltages are applied where necessary to compensate for the difference in pinch-off voltages of the selected FETs.

In U.S. Patent No. 3,818,244 and 3,737,678 to Dolby et al, reproducibility of FET conductance control characteristics is improved by employing two FETs with pinch-off voltages selected to be identical to provide the attenuation required through two stages. The first FET provides the first few dB of attenuation, with most of the remaining required attenuation provided by the second FET, the two FETs having different thresholds of control voltage at which they start to conduct. A high degree of repeatability is achieved even at high values of attenuation because the first FET is fully conducting after the first few dB of attenuation, giving an accurate value of first stage attenuation.

In U.S. Patent No. 2,035,263, Cushman et al propose to use two identical variable resistance devices controlled in the same manner by the same control signal to provide a compression or expansion ratio of 2:1. In other words, for devices having a wide variety of conductance control characteristics, a precise and reproducible compression or expansion ratio of 2:1 can be achieved so long as the two variable resistance devices used in the compressor or expander are identical and identically controlled. In such manner matching companders can be produced even though the characteristics of variable resistance devices in one compander do not match those of devices in a different compander. Any number of variable resistance devices may be employed to provide different fractional compression and expansion ratios.

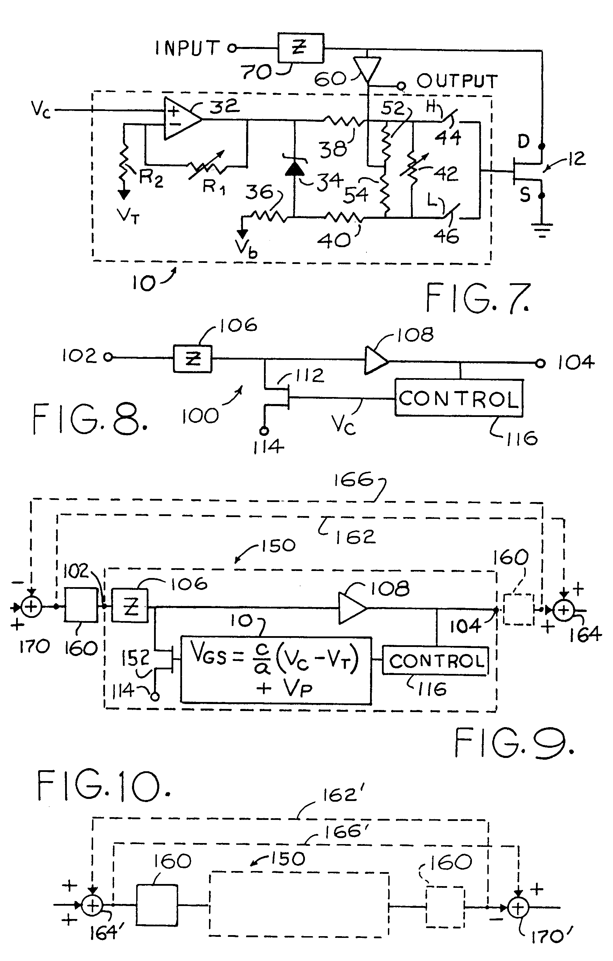

In the article "Compander Increases Dynamic Range" by Wermuth, db Magazine, June 1976, the use of three identical FETs (Fig. 8) is proposed in a scheme similar to that of Cushman et al's to achieve a compression ratio of 2:3 or by 33% on a logarithmic scale; the scheme enables the characteristic to be reproducible. In U.S. Patent 3,969,680 Wermuth proposes the use of two identical FETs in another similar scheme to provide constant slope 2:1 compression and expansion.

None of the above described conventional methods is entirely satisfactory. In some methods the FETs used must be selected from a limited group. For companders using identical devices, special manufacturing may again be required to produce these devices. Furthermore, the transient response of such companders may deviate significantly from the constant ratio in a manner dependent on the actual conductance control characteristics of the identical loss devices.

EP-A- 3509 (U.S. Patent No. 4,223,274 to Paulke et al.) describes an amplifier with three cascaded amplification stages each having a voltage controlled amplifier comprising a dual-gate MOSFET the gain of which can be adjusted by means of a control signal. Each voltage controlled amplifier has a control signal forming element for deriving a secondary control value from a primary control value according to a linear equation, so that the amplification of each of the stages may be controlled to conform to a commonly-prescribed characteristic. In EP-A- 3509 the input is applied to the other of the gates of the dual-gate MOSFET, and the drain and source are connected through resistors to a voltage source and ground respectively. Such an arrangement will provide a variable signal amplification, but will allow components of the control signal to appear as noise in the output of the device ("break through"). Thus the circuit is unsuitable for high quality signal processing requirements.

## Summary of the Invention

The present invention in its various aspects is defined in the appended claims, to which reference should now be made.

This invention is based on my recognition that the drain-source conductance of a wide variety of FETs can be made to conform to a predetermined function of a control signal by first modifying the control signal. The modified control signal is then applied to the gate of a FET. The modified control signal is derived in accordance with the desired predetermined function and the actual characteristics of the FET. When the modified control signal is applied to the FET gate, the drain-source conductance of the FET conforms to a predetermined function of the original unmodified control signal.

The drain-source conductance of the FET is a second function of the gate-source voltage. The FET is provided with means for providing a modified control signal by multiplying the received control signal by a factor and adding or subtracting therefrom an offset. The modified control signal is applied to the gate of the transistor. The factor and the offset are such that the drain-source conductance of the transistor is substantially the predetermined function of the control signal.

A circuit embodying the invention may be used to cause the drain-source conductance (resistance) of practically any FET to conform to a predetermined function of a control signal. No special type of FET or special manufacturing processes are required, so that attenuators, filters or other devices requiring FETs with reproducible conductance control characteristics may be produced cheaply and conveniently.

Preferably the invention is embodied in an attenuator circuit employing a FET and an impedance to provide attenuation which conforms to a desired and predetermined characteristic. The circuit can then provide a desired attenuator characteristic, where the desired characteristic is defined with respect to a reference (possibly notional) field effect transistor whose drain-source conductance is a predetermined function of a control voltage $V_C$ applied to the gate of the reference transistor, and where the predetermined function is of the form $F(c(V_C - V_T))$; c, $V_T$ being desired constants and F a selected function.

Such a circuit for providing a desired attenuator characteristic comprises an impedance means and a second field effect transistor whose drain-source conductance is substantially a function $F(a(V_{GS} - V_P))$ of its gate-source voltage $V_{GS}$, where constants a, $V_P$ are different from the desired constants c, $V_T$. The circuit further comprises means for providing a modified control signal by multiplying the control signal $V_C$ by a factor c/a and adding thereto an offset $(V_P - c/aV_T)$. The modified control signal is then applied to the gate of the second transistor. The multiplying factor and the offset are such that the drain-source conductance of the second transistor is substantially the predetermined function of the control signal. This causes the circuit characteristic to conform to the desired predetermined attenuator characteristic.

The invention is particularly suitable for use in circuits having a main path and a further path in a "dual path" arrangement, where the circuits provide compression or expansion which conforms to a desired and predetermined characteristic. Such a circuit can provide a desired compression or expansion characteristic where the characteristic is defined with respect to a field effect transistor whose drain-source conductance is a predetermined function of a control signal $V_C$ applied to the gate of the reference transistor, said function being of the form $F(c(V_C - V_T))$, where c and $V_T$ are desired constants and F a selected function. The circuit comprises a main signal path which is substantially linear with respect to dynamic range and a further signal path which has its input coupled to the input or output of the main path.

The further path includes (a) a second field effect transistor whose drain-source conductance is substantially a function $F(a(V_{GS} - V_P))$ of its gate-source voltage $V_{GS}$, wherein constants a and $V_P$ are different from the desired constants c and $V_T$ respectively; (b) an impedance means; and (c) means for providing a modified control signal by multiplying the control signal $V_C$ by a factor and adding thereto an offset, said modified control signal being applied to the gate of the second transistor, said factor and said offset being such that the drain-source conductance of the transistor is substantially the predetermined function of the control signal.

Where the circuit is a compressor, the circuit further comprises means in the main signal path for adding the outputs of the main and further paths. Where the circuit is an expander, the circuit further comprises means in the main signal path for subtracting the outputs of the main and further paths.

Brief Description of the Drawings

Figs. 1A, 1B, 1C are schematic circuit diagrams of three types of attenuator or filter circuits.

Figs. 2A, 2B, 2C are graphical illustrations of the signal transmission characteristics of the circuits of Figs. 1A, 1B, 1C respectively.

Fig. 3A is a graphical illustration of the drain-source conductance G as a desired predetermined function of a control signal $V_C$. Fig. 3B is a graphical illustration of the drain-source conductance $G_{DS}$ of a particular FET as a function of the gate voltage $V_{GS}$.

Fig. 4 is a block diagram of a circuit for modifying the control signal $V_C$ so that, when the modified control signal is applied to the gate of the FET with conductance control characteristics as shown in Fig. 3B, substantially the desired predetermined conductance control characteristics of Fig. 3A will be obtained.

Fig. 5 is the block diagram of Fig. 4 and of a circuit for reducing signal distortion.

Fig. 6 is a block circuit diagram of an implementation of the circuit of Fig. 5.

Fig. 7 is a schematic circuit diagram of a practical implementation of the circuit of Fig. 5, illustrating the preferred embodiment of the invention.

Fig. 8 is a schematic circuit diagram of an attenuator circuit useful in compressors and expanders.

Fig. 9 is a schematic circuit diagram illustrating the preferred embodiment of the invention.

Fig. 10 is a schematic circuit diagram illustrating an alternative embodiment of the invention.

Description of the Invention

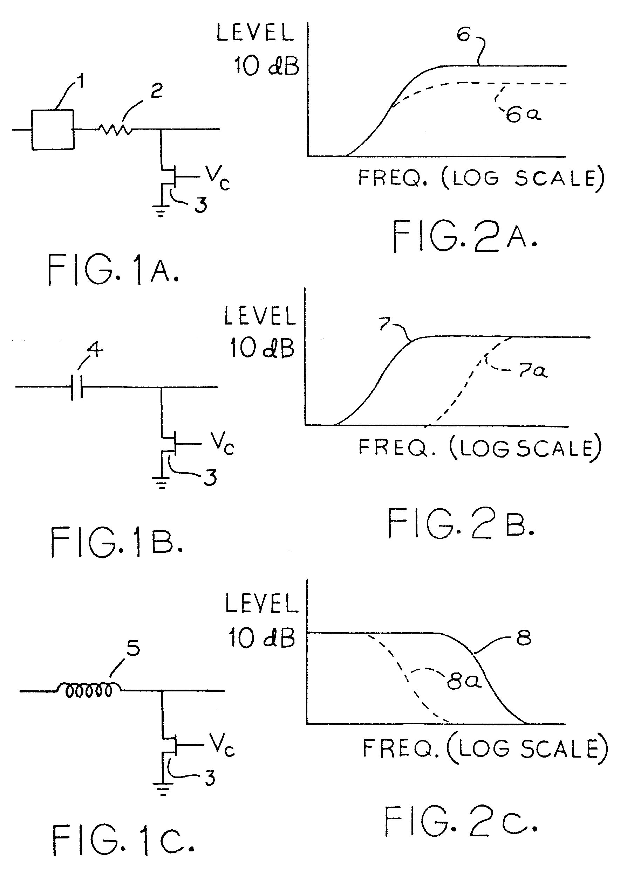

Fig. 1A is a schematic circuit diagram illustrating a fixed band attenuator. As shown in Fig. 1A, the fixed band attenuator comprises a filter 1 and a voltage divider comprising resistor 2 and a field effect transistor 3. The drain-source resistance of transistor 3 is variable as a function of control voltage $V_C$. The frequency response characteristic curve 6 of the circuit of Fig. 1A is illustrated in Fig. 2A, where fixed filter 1 is assumed to be a high pass filter with a fixed high frequency shelf response. Thus, the effect of the voltage divider circuit comprising resistor 2 and FET 3 is to move the level of the shelf 6 vertically, such as to a position 6a shown in dotted line in Fig. 2A. Thus, the amount of attenuation applied by the circuit in the pass band is controlled by the drain-source resistance of the FET, where the resistance is in turn controlled by control signal $V_C$; the corner frequency of the high frequency shelf 6 does not change with changes in the control signal $V_C$.

Fig. 1B is a schematic circuit diagram illustrating a sliding band high pass filter comprising FET 3 and capacitor 4 arranged as shown. The characteristics of the circuit of Fig. 1B are illustrated in Fig. 2B. The characteristic curve 7, as shown in Fig. 2B, is in the shape of a high frequency shelf whose corner frequency may slide upwards as a function of the control signal $V_C$. Thus, as shown in Fig. 2B, depending on the control signal $V_C$, the characteristic curve of the circuit may shift upwards to a position shown in dotted line 7a.

Fig. 1C is a schematic circuit diagram of a sliding band low pass filter comprising FET 3 and an inductor 5 (simulated by a gyrator circuit as a practical matter). Its characteristics are illustrated in Fig. 2C. As shown in Fig. 2C, characteristic curve 8 of the circuit is in the shape of a low frequency shelf whose corner frequency may slide downwardly as a function of the control signal $V_C$. Depending on the signal $V_C$, the characteristic curve of the circuit of Fig. 1C may shift to the left to a position shown in dotted line 8a.

In the circuit of Fig. 1A, the amount of attenuation in the pass band is controlled by $V_C$, which causes the drain-source resistance of the FET to vary without changing the corner frequency. In the circuit of Fig. 1B, control signal $V_C$ controls the time constant of the circuit and therefore the sliding action described above by controlling the drain-source resistance of FET 3. In the circuit of Fig. 1C, control signal $V_C$ controls the sliding action by varying the drain-source resistance of FET 3. The drain-source resistance of a FET is simply the reciprocal of its drain-source conductance. In other words, the attenuation characteristics of the circuits of Figs. 1A-1C depend on the conductance control characteristics of the FETs in such circuits.

As discussed above in the Background of the Invention, it is desirable for signal attenuators in a group of matching compressors (or expanders) to have substantially identical characteristics. Since different FETs may have very different conductance control characteristics, their drain-source resistances may be very different even though the same control signal is applied to their gates. It is therefore desirable to provide circuits which can cause the conductance control characteristic of any FET to conform to a desired predetermined characteristic. Thus, even though FETs having very different conductance control characteristics are used in the attenuator circuits described above, the attenuation applied can be made to conform to a desired and predetermined characteristic.

The aspect of the invention directed to conforming the conductance control characteristics of FETs to a predetermined characteristic is described below in reference to Figs. 3A, 3B, 4-7. It is known that the drain-source conductance of a FET is proportional to the quantity

$$V_{GS} - V_{DS}/2 - V_T ,$$

where

    $V_{GS}$ is the gate-source voltage,
    $V_{DS}$ is the drain-source voltage, and
    $V_T$ is a threshold voltage of the FET.

The distortion term $V_{DS}/2$ in the expression above will be dealt with later and may be neglected for now so that the drain-source conductance G may be expressed as follows:

$$G = c(V_{GS} - V_T)$$

where c is a constant characteristic of a particular FET. Thus, if a control voltage $V_C$ is applied to the gate of the FET with its source grounded, the conductance G is given by:

$$G = c(V_C - V_T)$$

The desired conductance control characteristic of the FET is thus in the shape of a straight line the slope of which determines the scale for the change in drain-source conductance of the FET when the control voltage $V_C$ changes. The desired conductance control characteristic is illustrated in Fig. 3A.

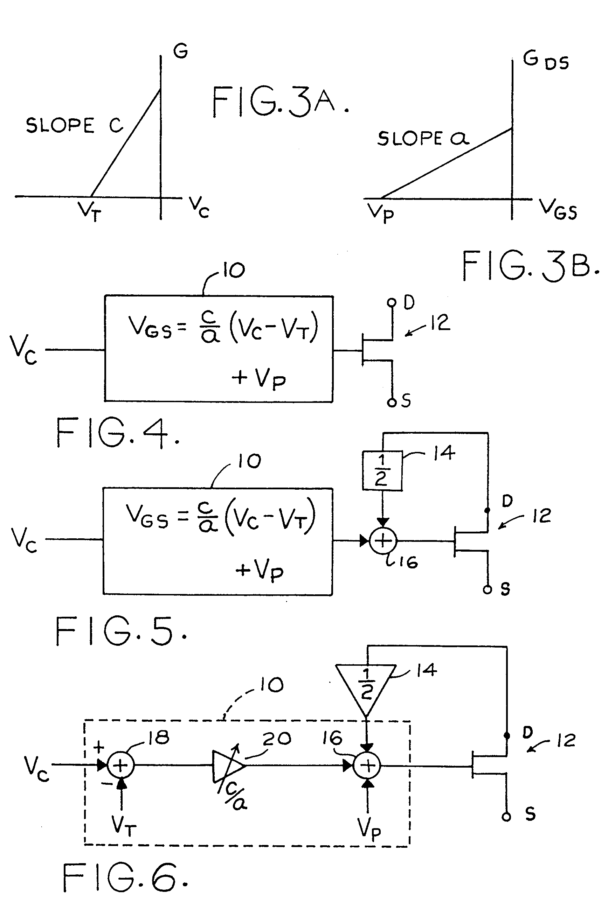

In many applications such as in noise reduction systems employing precisely controlled compression and expansion, it is desirable to provide conductances which are predetermined functions of a control signal, such as that shown in Fig. 3A. However, it is difficult to manufacture a large number of FETs having the same desired conductance control characteristic. I have appreciated that it would be desirable to provide for a circuit which, when used in conjunction with any FET having a conductance control characteristic different from the one desired, will cause the FET to provide a conductance which varies in accordance with the desired characteristic. One such FET may for example have the characteristic shown in Fig. 3B. A comparison of Figs. 3A and 3B will show that the FET of Fig. 3B has a conductance control characteristic very different from the desired characteristic of Fig. 3A.

This invention is based on my recognition that given any FET whose conductance control characteristic takes on the same general function or dependence upon a control signal as that desired, a circuit may be provided to modify the control signal applied to the FET gate so that the FET will have the desired conductance control characteristic. The conductance of the FET must take on the same general form of functional dependence upon a control signal. Thus, if the desired conductance control characteristic is in the form of a straight line as shown in Fig. 3A, the conductance control characteristic of the FET employed must also be a straight line. The conductance control characteristic of the FET illustrated in Fig. 3B may be represented as follows:

$$G_{DS} = a(V_{GS} - V_P)$$

where

    a is a constant characteristic of the FET and
    $V_P$ is the pinch-off voltage of the FET.

In order that the drain-source conductance $G_{DS}$ be the same as the desired conductance G of Fig. 3A the following must hold:

$$a(V_{GS} - V_P) = c(V_C - V_T)$$

or,

$$V_{GS} = (c/a)(V_C - V_T) + V_P$$

Thus, if the control voltage $V_C$ is applied between the gate and source of the FET of Fig. 3B, then the conductance control characteristic as illustrated in Fig. 3B will be obtained. If, however, instead of applying the control voltage $V_C$ between the gate and source of the FET, a modified control voltage $V_{GS}$ given by the above equation is applied instead, the drain-source conductance $G_{DS}$ will be equal to the conductance G having the desired characteristic dependence on $V_C$.

Fig. 4 is a block diagram of a circuit for modifying the control voltage before application to the FET so that the FET will have the desired conductance control characteristic. As shown in Fig. 4, circuit 10 modifies the control voltage $V_C$ so that when the modified control voltage $V_{GS}$ is applied between the gate and source of the FET 12, the drain-source conductance of FET 12 will have the desired control characteristic dependence on $V_C$.

Fig. 5 is a block diagram incorporating the circuit of Fig. 4 together with a circuit for reducing distortion. As shown in Fig. 5 the drain-source voltage across the FET 12 is first reduced to half of its instantaneous magnitude by circuit 14 and then added to the modified control voltage $V_{GS}$ before application to the gate of the FET. The application of half the drain-source voltage to the gate of the FET is conventionally employed to reduce distortion. This corresponds to the distortion term in the general expression for the conductance of the FET above.

Fig. 6 is a schematic circuit diagram illustrating an implementation of the circuit of Fig. 5. As shown in Fig. 6. the pinch-off voltage $V_T$ of the desired conductance control characteristic is first subtracted from the control voltage by adder 18. The difference voltage is then supplied to a variable gain amplifier 20 which multiplies the difference voltage by the factor $c/a$. The output of amplifier 20 is then added to $V_P$, the actual pinch-off voltage of FET 12, to obtain the modified control signal $V_{GS}$ of circuit 10 of Fig. 5. However, since the modified control signal is to be added also to the half of the drain-source voltage $V_{DS}$ of FET 12 by adder 16, an additional adder may be eliminated by having the two additions performed together by adder 16, adding together the three quantities in adder 16: $(c/a)(V_C-V_T)$, $V_P$, $1/2\ V_{DS}$. As shown in Fig. 6 an amplifier having the gain of half is used for the multiplier 14 to provide a low input impedance for adder 16.

Given a FET 12 having a conductance control characteristic of a straight line in the form of Fig. 3B, the adjustable elements in circuit 10 may be easily adjusted so that the drain-source conductance of FET 12 conforms substantially to that desired. The quantities $V_T$ and c are known since they characterize the desired conductance control characteristic. The actual pinch-off voltage of FET 12, $V_P$, can be found by simple testing. Thus, all the settings of circuit 10 are known except for the quantity a. Therefore, to complete the calibration of FET 12, the gain of amplifier 20 is adjusted until the drain-source conductance of FET 12 conforms to that required at a particular value of the control voltage $V_C$. The calibration of FET 12 is then complete.

Fig. 7 is a schematic circuit diagram of a practical implementation of the circuit of Fig. 5 to illustrate the preferred embodiment of the invention. As shown in Fig. 7, the control voltage $V_C$ is fed to the non-inverting input of an amplifier 32. The inverting input of the amplifier is biased by a DC voltage equal to the desired pinch-off voltage $V_T$ through a resistor $R_2$. The output of the amplifier 32 is fed back to the inverting input through an adjustable resistor $R_1$. The output of amplifier 32 is given by the expression below:

$$(R_1 + R_2)(V_C - V_T)/R_2 + V_T$$

The voltage divider circuit comprising Zener diode 34, biasing voltage $V_b$, biasing resistor 36 and voltage divider resistors 38, 40, 42, adds the offset voltage $(V_P - V_T)$ to the output of amplifier 32. Hence, if the ratio $(R_1 + R_2) / R_2$ is equal to the ratio $c/a$, then the voltage applied across the gate and source of FET 12 in Fig. 7 is given by the equation of circuit 10 in Fig. 5. Voltage $V_b$ and biasing resistor 36 bias the Zener diode into conduction. Zener diode 34 provides a substantially constant DC voltage drop between its cathode and anode. Such voltage drop is divided by the divider resistors 38, 40, 42 to provide offsets at the points H, L to generate the offset $(V_P -V_T)$. Thus, if connection 44 at point H is made, the offset provided is equal to the voltage drop across Zener diode 34 multiplied by the ratio given by the resistance of resistor 38 divided by the sum of the resistances of resistors 38, 40 and 42. If connection 46 is made at point L instead, the offset applied is given by the voltage drop across diode 34 multiplied by the ratio of the sum of the resistances of resistors 38, 42 to that of resistors 38, 40 and 42. Either one of the two connections 44, 46 may be made depending on the magnitude of $(V_P - V_T)$ required.

Resistors 38 and 40 may conveniently have substantially the same resistance. Then, if the resistance of resistor 42 is zero, both points H, L are at half the voltage drop of the Zener diode. When the resistance of resistor 42 is increased from zero, the voltage at H increases and that at L decreases from such half voltage drop value. Thus, if the magnitude of the offset required is greater than half the voltage drop across diode 34, connection 44 is made. If instead the offset is less than half the voltage drop across diode 34, connection 46 is made instead. Then the resistance of resistor 42 may be adjusted until the voltage at H or L reaches the required offset value. Zener diode 34 may be chosen so that its voltage drop is optimum for the variation in the offset voltage required.

The voltage across the drain and source of FET 12 is amplified by amplifier 60 and then applied through resistors 52, 54 to points H and L, respectively. Resistors 52 and 54 have substantially the same resistance which is of such a value that the AC components of the voltages at points H and L are substantially half of $V_{DS}$. As a practical matter, significant signal amplification, e.g. 20 dB, may be used in amplifier 60. The values of resistors 52 and 54 are then increased accordingly so as to maintain half of $V_{DS}$ at the FET gate. Configured as shown in Fig. 7 it will be observed that the generation of the offset voltage ($V_P - V_T$) does not affect the application of the distortion compensation voltage $V_{DS}/2$ and visa versa. Furthermore, the distortion compensation voltage $V_{DS}/2$ applied is unaffected by whether connection 44 or connection 46 is made. The input signal is fed to the drain of FET 12 through an impedance 70, and the signal output is taken from the output of amplifier 60.

FET 12 may be calibrated using the circuit of Fig. 7 by a simple procedure. First, either one of the two connections 44, 46 is made depending on the expected value of the offset voltage ($V_P - V_T$). Then $R_1$ and the value of resistor 42 are adjusted by a process of successive approximation until the drain-source conductance of FET 12 conforms to the desired conductance control characteristic. If the value of $R_2$ is set to provide a bias at the inverting terminal of amplifier 32, this bias corresponding to the FET gate pinch-off voltage, then the adjustment process becomes essentially non-iterative (i.e. convergence is rapid). Resistor 42 (bias) is set to give the lower conduction point. Resistor $R_1$ (gain) then calibrates the higher conduction point. If necessary, resistor 42 may be retrimmed and $R_1$ rechecked at the lower and higher conduction points respectively.

While the invention is described above in reference to FETs whose drain-source conductances are linear functions of the control voltage, it will be understood that the invention is also applicable to those in which the conductance is not a perfectly linear function of the control voltage. Thus, if the desired conductance control characteristic of a FET is given by:

$$G = F_1[c(V_C - V_T)],$$

the circuit of the invention is applicable to any FET whose conductance is given by:

$$G = F_2[a(V_{GS} - V_P)],$$

provided that $F_1$ is substantially the same as $F_2$.

The variable conductance of a FET conforming to a desired conductance control characteristic may be used in the signal path to attenuate the signal to a desired degree. Alternatively, it may be placed in a shunt path, shunting the signal to ground or to another terminal to attenuate the signal to the desired degree. A balanced circuit may be used if desired, the FET being connected there across. It may also be used together with a capacitance or inductance to form a high pass or a low pass filter with a variable corner frequency. Such configurations are useful in compressors and expanders in noise reduction circuits. All such arrangements are within the scope of this invention.

Fig. 8 is a schematic circuit diagram of a signal attenuator useful in compressors and expanders. As described in detail in US-PS 3,846,719; US-PS 3,903,485; US-PS 4,490,691 and US-PS Re 28,426, audio noise reduction systems advantageously employed "dual path" arrangements. A "dual path" arrangement is one in which a compression or expansion characteristic is achieved through the use of a main path which is essentially free of dynamic action and one or more secondary or side paths having dynamic action. The side path or paths take their input from the input or output of the main path and the output or outputs are additively or subtractively combined with the main path in order to provide compression or expansion. Generally, a side path provides a type of limiting or variable attenuation and the manner in which it is connected to the main path determines if it boosts (to provide compression) or bucks (to provide expansion) the main path signal components. Circuit 100 of Fig. 8 may be advantageously used in the side path of a dual path arrangement to provide the desired compression or expansion.

Signal attenuator 100 of Fig. 8 comprises an input port 102, an output port 104, an impedance 106 and a buffer 108 connected between the input and the output. The output of impedance 106 is shunted by the drain-source path of a FET 112 to a port 114. The gate of FET 112 is controlled by a control signal $V_C$ derived by a control circuit 116 from the output 104 and fed back to the gate of the transistor. Control circuit 116 may be a rectifier and smoothing circuit. Thus, the output signal at output 104 controls the shunting action of FET 112 by the feedback loop through control circuit 116.

If impedance 106 is a resistor, then resistor 106 and the drain-source path of FET 112 forms a voltage divider where the signal attenuation may be simply varied by varying the drain-source resistance of FET 112. As discussed above in reference to Figs. 1A, 2A, circuit 100 (where impedance 106 is a resistor), when used with another high pass filter (not shown in Fig. 8), forms a fixed band filter with characteristics as shown in Fig. 2A. Thus, variation in the drain-source resistance of the FET 112 will simply cause the level of the high frequency shelf in Fig. 2A to shift vertically, without changing the corner frequency.

Where impedance 106 is a capacitor, circuit 100 is a sliding band high pass filter with characteristics illustrated in Fig. 2B. Where impedance 106 is an inductor (simulated as a practical matter by a gyrator circuit), circuit 100 is a sliding band low pass filter with characteristics illustrated in Fig. 2C. Where the impedance 106 is a capacitor or an inductor, the sliding action of the corner frequency of the filter is controlled by the drain-source resistance of the FET. Thus, irrespective of whether impedance 106 is a resistor, inductor or capacitor, in order for signal attenuator 100 to provide the desired attenuation characteristics, it is necessary for the drain-source conductance characteristic of FET 112 to conform to a desired and predetermined reference characteristic.

For the purpose of discussion, it is assumed that the desired conductance control characteristic of a reference FET 112 is given by:

$$G = F\,[c(V_C - V_T)],$$

where c, $V_T$ are desired constants and F is a selected function. Then, as shown above, the conductance control characteristics of any FET can be made to conform to the desired conductance control characteristic of reference FET 112 by means of the modifying circuit 10 of FIGs. 4-7, provided that the conductance control characteristic of such FET is substantially of the form:

$$G = F\,[a(V_{GS} - V_P)],$$

where a, $V_P$ are constants and $V_{GS}$ is the gate-source voltage of such FET. For most FETs, their conductance control characteristics are linear so that their conductance control characteristics are of the form:

$$G = a(V_{GS} - V_P)].$$

While, for the purpose of discussion, a reference FET is used to define the desired attenuator characteristics, it will be understood that as a practical matter no reference FET is necessary so long as the desired conductance control characteristics for the FET to be used are known. This information may then be used as shown below to cause an attenuator circuit using any FET having the same functional dependence on control signals to have substantially the desired characteristics.

Fig. 9 is a schematic circuit diagram of a signal attenuator illustrating another aspect of the invention. Attenuator circuit 150 includes the impedance 106, buffer 108 and control circuit 116 of Fig. 8. FET 152, however, has conductance control characteristics that are different from the desired reference characteristic. In order that circuit 150 will provide the same attenuation characteristics as circuit 100 of Fig. 8, a circuit 10 is employed to modify the control signal $V_C$ from control circuit 116; the modified control signal $V_{GS}$ is then applied to the gate of FET 152. As shown above, circuit 10 will cause the conductance control characteristics of FET 152 to conform to that of the reference characteristic (e.g. that of FET 112). Hence, the attenuation circuit 150 will have essentially the same attenuation characteristics as circuit 100 of Fig. 8.

In certain compressor and expander circuit arrangements, it may be desirable to divide the audio spectrum into a plurality of frequency bands, each of which is acted upon independently. In that way, a dominant signal component affects dynamic action (compression or expansion) only within a portion of the overall spectrum, in contrast to a wideband approach in which dynamic action throughout the entire spectrum is affected by a dominant signal component. In such bandsplitting approach, it may be desirable to employ a filter in the side path circuit. As shown in Fig. 9, a filter 160 may be used to filter the input signal of circuit 150. Filter 160 may be a band pass filter, a low pass filter or a high pass filter. Alternatively filter 160 may be placed at the output of circuit 150 to filter its output instead as shown in phantom in Fig. 9. Where circuit 150 is used in a side path of a low frequency stage of a bandsplitting arrangement, it is preferable for the low pass filter in the side path to be placed at the output of circuit 150. When placed at such position, the low pass filter assists in suppressing undesired noise or distortion generated in the low frequency stage.

As shown in Fig. 9, the side or further path comprising circuit 150 may be combined with a main path 162 shown in dotted line and adder 164 in the main path to form a compressor. Thus adder 164 adds the outputs of both the main and further paths to give the output of the compressor. In the compressor combination, it will be noted that the input of the further path is coupled to the input of the main path. Alternatively, the further path comprising circuit 150 may be combined with main path 166 shown in dotted line and adder 170 in the main path to form an expander. Adder 170 subtracts the output of the further path from the output of the main path to give the expander output. It will be noted that the input of the further path in the expander is coupled, not to the input of the main path, but to its output instead. The compressor and expander described above are referred to as the Type I compressor and expander in U.S. Patent No. 3,903,485 to the applicant.

Fig. 10 is a block diagram illustrating an alternative embodiment of the invention. As shown in Fig. 10, the further path comprising circuit 150 may be combined with a main path 162' and an adder 164' in the main path to form a compressor different from that of Fig. 9. As described in U.S. Patent No. 3,903,485, the above described compressor of Fig. 10 is a Type II compressor. Adder 164' adds the outputs of the two paths to give the compressor output. Similarly, the further path comprising circuit 150 may also be combined with main path 166' and adder 170' as shown in Fig. 10 to form a type II expander. Adder 170' subtracts the further path output from the main path output to give the expander output.

In both the Type I and II arrangements, the compression and expansion characteristics depend on the attenuation applied in the further paths, in other words, on the attenuation characteristics of circuit 150 which in turn depends on the conductance control characteristics of FET 112. As described above, the attenuation or filter characteristics of circuit 150 can be made to conform to a desired predetermined characteristic using control signal modifying circuit 10 of Figs. 4-7. Hence, if a desired compression or expansion characteristic is defined by combining a further path comprising circuit 150 of Fig. 9 with a main path in either the Type I or II arrangement and with respect to a reference FET characteristic (e.g. FET 112), any compressor or expander with the same type of arrangement but using a FET with characteristics different from that desired may be made (using circuit 10 as shown in Fig. 9) to conform to the desired compression or expansion characteristic by causing the conductance control characteristic of the FET to be used to conform to that of the reference FET characteristic.

## Claims

1. A circuit for providing a variable resistance the conductance of which is a predetermined function of a received control signal Vc of the form $F(c(V_C-V_T))$, where c and $V_T$ are desired constants and F is a selected function, the circuit comprising a field effect transistor (12) the drain-source conductance of which is substantially a function $F(a(V_{GS}-V_P))$ of its gate-source voltage $V_{GS}$, the constants a and $V_P$ being different from the desired constants c and $V_T$ respectively; a controlled signal input (D) connected to the drain-source path of the transistor; and means (10) for providing a modified control signal by multiplying the received control signal by a factor and adding thereto an offset, the modified control signal being so applied to the gate of the transistor and the factor and the offset being such that the drain-source conductance of the transistor is substantially the predetermined function of the received control signal.

2. A circuit for attenuating a controlled signal by means of a variable resistance the conductance of which is a predetermined function of a received control signal $V_C$ of the form $F(c(V_C-V_T))$, where c and $V_T$ are desired constants and F is a selected function, the resistance being suitable for controllably attenuating the controlled signal in a manner in accordance with the predetermined function, the circuit comprising a field effect transistor (12) the drain-source conductance of which is substantially a function $F(a(V_{GS}-V_P))$ of its gate-source voltage $V_{GS}$, the constants a and $V_P$ being different from the desired constants c and $V_T$ respectively, and the controlled signal being applied between the drain and source of the transistor; and means (10) for providing a modified control signal by multiplying the received control signal by a factor and adding thereto an offset, said modified control signal being so applied to the gate of the transistor and the factor and the offset being such that the drain-source conductance of the transistor is substantially the predetermined function of the received control signal, so that the controlled signal is controllably attenuated by the transistor in accordance with the predetermined function.

3. A circuit according to claim 2, further comprising a path between a controlled signal input (102) and a controlled signal output (104), the path including an impedance means (106), the drain (D) of the field effect transistor being connected to the path such that the drain-source path of the transistor shunts the path, so that the transistor and impedance means provide desired attenuation characteristics to a signal applied to the controlled signal input.

4. A circuit according to claim 3, further comprising means (116) for generating, from the output of the circuit, the control signal $V_C$ for controlling the attenuation of a signal at the controlled signal input, the control signal generating means (116) and modified control signal providing means (10) forming a feedback path from the controlled signal output (104) to the gate (G) of the transistor.

5. A circuit according to claim 4, further comprising a fixed band filter (160) connected to filter input signals to the impedance means (106).

6. A circuit according to claim 4, further comprising a fixed band filter (160) connected between the output (104) and the drain of the transistor (152) to filter the output signals of the transistor.

7. A circuit according to claim 5 or 6, in which the fixed band filter is a bandpass filter.

8. A circuit according to claim 5 or 6, in which the fixed band filter is a high-pass filter.

9. A circuit according to claim 5 or 6, in which the fixed band filter is a low-pass filter.

10. A circuit according to any at claims 3 to 9, in which the impedance means is a resistor, the circuit acting as fixed band filter.

11. A circuit according to any of claims 3 to 9, in which the impedance means is a capacitor, the circuit acting as a sliding-band high-pass filter.

12. A circuit according to any of claims 3 to 9, in which the impedance means includes an inductor means, the circuit acting as a sliding-band low-pass filter.

13. A circuit according to any of claims 3 to 12, further comprising a main signal path (162; 166; 162'; 166') which is substantially linear with respect to dynamic range, and means (164; 170; 164'; 170') for combining the outputs of the main signal path and the path (150) containing the impedance means (106), the input of the path containing the impedance means being coupled to the input or output of the main path.

14. A circuit according to any preceding claim, in which the predetermined function is of the form:

$$G = c(V_C - V_T);$$

where G is the desired conductance.

15. A circuit according to claim 14, in which the drain-source conductance of the field effect transistor is of the form:

$$G_{DS} = a(V_{GS} - V_P);$$

where $G_{DS}$ is the drain-source conductance of the transistor, and $V_P$ is the pinch-off voltage of the transistor.

16. A circuit according to claim 15, in which the means (10) for providing a modified control signal comprises means (18) for subtracting the constant $V_T$ from the control signal $V_C$ to provide a difference signal; means (20) for multiplying the difference signal by substantially the factor c/a to provide a product signal substantially equal to $(c/a)(V_C - V_T)$; and means (16) for adding $V_P$ to the product signal to derive the modified control signal, so that the modified control signal, when applied to the gate of the transistor (12), will cause the drain-source conductance of the transistor to be substantially the predetermined function of the control signal $V_C$.

17. A circuit according to claim 16, further comprising means (14) for applying substantially half the drain-source voltage of the transistor to the gate of the transistor to reduce distortion.

18. A circuit according to claim 15, 16 or 17, in which the modified control signal providing means (10) comprises an amplifier (32) with the control signal applied to the non-inverting input of the amplifier; a negative feedback path to the inverting input of the amplifier, and containing an adjustable resistance $R_1$; a resistance $R_2$ connecting a DC voltage supply to the inverting input of the amplifier, the resistance $R_1$ being adjusted so that the ratio $(R_1 + R_2)/R_2$ is substantially equal to c/a; and means (34-42) for adding an offset to the output of the amplifier to derive the modified control signal, said offset being selected so that the modified control signal, when applied to the gate of the transistor, will cause the drain-source conductance of the transistor to be substantially the predetermined function of the control signal $V_C$.

19. A circuit according to claim 18, in which the DC voltage is substantially equal to $V_T$, and the offset is selected to be substantially equal to $(V_P - V_T)$.

20. A circuit according to claim 19, in which the value of $V_T$ is set so that substantially the voltage $V_P$ is applied to the gate of the transistor to simplify a process for adjusting the values of $R_1$ and the offset.

21. A circuit according to claim 18, 19 or 20, in which the offset adding means comprises voltage divider means (38-42) for deriving the offset from a second DC voltage, the divider means having an adjustable resistance path adjusted so that the offset derived is substantially $(V_P - V_T)$.

22. A circuit according to claim 21, further comprising a Zener diode (34) with a selected Zener voltage for supplying the second DC voltage; and means (38-42) for biasing the Zener diode so that the diode is operating in its reverse breakdown region, the diode being connected to the output of the amplifier (32) to provide an alternative voltage substantially equal to the output voltage of the amplifier reduced by the Zener voltage.

23. A circuit according to claim 22, in which the voltage divider means comprises a first fixed resistor (38), a variable resistor (42) and a second fixed resistor (40) connected in series, a node between the first fixed resistor and the variable resistor defining the H node and a node between the second fixed resistor and the variable resistor defining the L node, the two fixed resistors (38,40) having the other ends connected to the cathode and anode of the diode (34), so that one of the two nodes H, L will provide the modified control signal at a desired DC level for the transistor.

24. A circuit according to claim 23, in which the first and second resistors (38,40) have substantially the same resistance.

25. A circuit according to both claim 17 and claim 24, in which the means (14) for applying half the drain-source voltage comprises means (44,46) for connecting the gate of the transistor to either the H or L node; a third and fourth resistor (52,54) of substantially the same value connected in series between the H and L nodes; and means (60) for applying a multiple of the drain-source voltage of the transistor to the junction between the third and fourth resistors, the value of the third and fourth resistors bearing such ratio to the value of the first and second resistors that half of the drain-source voltage of the transistor is applied to the gate of the transistor.

26. A method of controlling a variable resistance the conductance of which is a predetermined function of a control signal $V_C$ of the form $F(c-(V_C-V_T))$, where c and $V_T$ are desired constants and F is a selected function, the method comprising the steps of providing a field effect transistor the drain-source conductance of which is substantially a function $F(a(V_{GS}-V_P))$ of its gate-source voltage $V_{GS}$, the constants a and $V_P$ being different from the desired constants c and $V_T$ respectively; modifying the control signal by multiplying the control signal by a factor and adding thereto an offset, and applying the modified control signal to the gate of the transistor; the factor and the offset being such that the drain-source conductance of the transistor is substantially the predetermined function of the received control signal.

**Patentansprüche**

1. Schaltung zur Schaffung eines veränderbaren Widerstands, dessen Leitwert eine vorbestimmte Funktion eines empfangenen Steuersignals $V_C$ der Form $F(c(V_C - V_T))$ ist, wobei c und $V_T$ gewünschte Konstanten und F eine ausgewählte Funktion sind und die Schaltung einen Feldeffekttransistor (12), dessen Drain-Source-Leitwert im wesentlichen eine Funktion $F(a(V_{GS}-V_P))$ seiner Gate-Source-Spannung $V_{GS}$ ist, wobei die Konstanten a und $V_P$ verschiedenen von den gewünschten Konstanten c bzw. $V_T$ sind, einen mit der Drain-Source-Strecke des Transistors verbundenen Eingang (D) für ein gesteuertes Signal und Mittel (C) aufweist zur Lieferung eines modifizierten Steuersignals durch Multiplikation des empfangenen Steuersignals mit einem Faktor und Hinzuaddieren eines Offsets, wobei das modifizierte Steuersignal so an das Gate des Transistors angelegt wird und der Faktor und der Offset derart sind, daß der Drain-Source-Leitwert des Transistors im wesentlichen die vorbestimmte Funktion des empfangenen Steuersignals ist.

2. Schaltung zur Dämpfung eines gesteuerten Signals mit Hilfe eines variablen Widerstands, dessen Leitwert eine vorbestimmte Funktion eines empfangenen Steuersignals $V_C$ der Form $F(c(V_C - V_T))$ ist, wobei C und $V_T$ gewünschte Konstanten und F eine ausgewählte Funktion sind und der Widerstand zur steuerbaren Dämpfung des gesteuerten Signals in einer der vorbestimmten Funktion entsprechenden Weise geeignet ist, wobei die Schaltung umfaßt: einen Feldeffekttransistor (12), dessen Drain-Source-Leitwert im wesentlichen eine Funktion $F(a(V_{GS} - V_P))$ seiner Gate-Source-Spannung $V_{GS}$ ist, wobei die Konstanten a und $V_P$ verschieden von den gewünschten Konstanten c bzw. $V_T$ sind und das gesteuerte Signal zwischen Drain und Source des Transistors angelegt wird, und eine Einrichtung (10) zur Lieferung eines modifizierten Steuersignals durch Multiplizieren des empfangenen Steuersignals mit einem Faktor und Hinzuaddieren eines Offsets, wobei das modifizierte Steuersignal so an das Gate des Transistors angelegt und der Faktor und der Offset so sind, daß der Drain-Source-Leitwert des Transistors im wesentlichen die vorbestimmte Funktion des empfangenen Steuersignals ist, so daß das gesteuerte Signal von dem Transistor nach Maßgabe der vorbestimmten Funktion steuerbar gedämpft wird.

3. Schaltung nach Anspruch 2, ferner umfassend einen Weg zwischen einem Eingang (102) für das gesteuerte Signal und einem Ausgang (104) für das gesteuerte Signal, der eine Impedanzeinrichtung (106) enthält, wobei die Drain (D) des Feldeffekttransistors derart mit dem Weg verbunden ist, daß die Drain-Source-Strecke des Transistors den Weg shuntet, so daß der Transistor und die Impedanzeinrichtung einem an den Eingang für das gesteuerte Signal angelegten Signal gewünschte Dämpfungseigenschaften verleiht.

4. Schaltung nach Anspruch 3, ferner umfassend eine Einrichtung (116) zur Erzeugung, anhand des Ausgangssignals der Schaltung, des Steuersignals $V_C$ zur Steuerung der Dämpfung eines Signals an dem Eingang für das gesteuerte Signal, wobei die Steuersignalerzeugungseinrichtung (116) und die Einrichtung (10) zur Lieferung eines modifizierten Steuersignals einen Rückkopplungsweg von dem Ausgang (104) für das gesteuerte Signal zu dem Gate (G) des Transistors bilden.

5. Schaltung nach Anspruch 4, ferner umfassend ein Festbandfilter (160), daß angeschlossen ist, um Eingangssignale zur Impedanzeinrichtung (106) zu filtern.

6. Schaltung nach Anspruch 4, ferner umfassend ein Festbandfilter (160), das zwischen den Ausgang (104) und die Drain des Transistors (152) geschaltet ist, um die Ausgangssignale des Transistors zu filtern.

7. Schaltung nach Anspruch 5 oder 6, bei der das Festbandfilter ein Bandpaßfilter ist.

8. Schaltung nach Anspruch 5 oder 6, bei der das Festbandfilter ein Hochpaßfilter ist.

9. Schaltung nach Anspruch 5 oder 6, bei der das Festbandfilter ein Tiefpaßfilter ist.

10. Schaltung nach einem der Ansprüche 3 bis 9, bei der die Impedanzeinrichtung ein Widerstand ist und die Schaltung als Festbandfilter wirkt.

11. Schaltung nach einem der Ansprüche 3 bis 9, bei der die Impedanzeinrichtung ein Kondensator ist und die Schaltung als ein Gleitband-Hochpaßfilter wirkt.

12. Schaltung nach einem der Ansprüche 3 bis 9, bei der die Impedanzeinrichtung eine induktive Einrichtung enthält und die Schaltung als ein Gleitband-Tiefpaßfilter wirkt.

13. Schaltung nach einem der Ansprüche 3 bis 12, ferner umfassend einen Hauptsignalweg (162; 166; 162'; 166'), der in bezug auf den Dynamikbereich im wesentlichen linear ist, und eine Einrichtung (164; 110; 164'; 170') zum Kombinieren der Ausgangssignale des Hauptsignalwegs und des die Impedanzeinrichtung (106) enthaltenden Wegs (150), wobei der Eingang des die Impedanzeinrichtung enthaltenden Wegs mit dem Eingang oder dem Ausgang des Hauptwegs gekoppelt ist.

14. Schaltung nach einem der vorhergehenden Ansprüche, bei der die vorbestimmte Funktion die Form

$$G = c(V_C - V_T)$$

hat, wobei G der gewünschte Leitwert ist.

15. Schaltung nach Anspruch 14, bei der der Drain-Source-Leitwert des Feldeffekttransistors die Form

$$G_{DS} = a(V_{GS} - V_P)$$

hat, wobei $G_{DS}$ der Drain-Source-Leitwert des Transistors und $V_P$ die Abschnürspannung des Transistors sind.

16. Schaltung nach Anspruch 15, bei der die Einrichtung (10) zur Lieferung eines modifizierten Steuersignals umfaßt: eine Einrichtung (18) zum Subtrahieren der Konstanten $V_T$ von dem Steuersignal $V_C$ zur Lieferung eines Differenzsignals; eine Einrichtung (20) zum Multiplizieren des Differenzsignals im wesentlichen mit dem Faktor c/a zur Lieferung eines Produktsignals im wesentlichen gleich $(c/a)(V_C - V_T)$ und eine Einrichtung (16) zum Addieren von $V_P$ zu dem Produktsignal zur Ableitung des modifizierten Steuersignals, so daß das modifizierte Steuersignal, wenn es an das Gate des Transistors (12) angelegt, wird verursacht, daß der Drain-Source-Leitwert des Transistor im wesentlichen die vorbestimmte Funktion des Steuersignals $V_C$ ist.

17. Schaltung nach Anspruch 16, ferner umfassend eine Einrichtung (14) zum Anlegen von im wesentlichen der halben Drain-Source-Spannung des Transistors an das Gate des Transistors zu Verzerrungsminderung.

18. Schaltung nach Anspruch 15, 16 oder 17, bei der die Einrichtung (10) zur Lieferung des modifizierten Steuersignals umfaßt: eine Verstärker (32), an dessen nicht-invertierenden Eingang das Steuersignal angelegt wird; einen einen einstellbaren Widerstand $R_1$ enthaltenden Gegenkopplungsweg zum invertierenden Eingang des Verstärkers; einen eine Gleichspannungsversorgung mit dem invertierenden Eingang des Verstärkers verbindenden Widerstand $R_2$, wobei der Widerstand $R_1$ so eingestellt wird, daß das Verhältnis $(R_1 + R_2)/R_2$ im wesentlichen gleich c/a ist; und eine Einrichtung (34-42) zum Addieren eines Offsets zum Ausgangssignal des Verstärkers zur Ableitung des modifizierten Steuersignals, wobei der Offset so ausgewählt wird, daß das modifizierte Steuersignal, wenn es an das Gate des Transistors angelegt wird, verursacht, daß der Drain-Source-Leitwert des Transistors im wesentlichen die vorbestimmte Funktion des Steuersignals $V_C$ ist.

19. Schaltung nach Anspruch 18, bei der die Gleichspannung im wesentlichen gleich $V_T$ ist und der Offset zu im wesentlichen gleich ($V_P$ - $V_T$) gewählt wird.

20. Schaltung nach Anspruch 19, bei der der Wert von $V_T$ so eingestellt wird, daß im wesentlichen die Spannung $V_P$ an das Gate des Transistors angelegt wird, um das Verfahren zur Einstellung der Werte von $R_1$ und des Offsets zu vereinfachen.

21. Schaltung nach Anspruch 18, 19 oder 20, bei der die Offsetaddiereinrichtung eine Spannungteilereinrichtung (38-42) zur Ableitung des Offsets von einer zweiten Gleichspannung umfaßt, wobei die Teilereinrichtung einen einstellbaren Widerstandsweg aufweist, der so eingestellt ist, daß der abgeleitete Offset im wesentlichen ($V_P$ - $V_T$) ist.

22. Schaltung nach Anspruch 21, ferner umfassend eine Z-Diode (34) mit einer ausgewählten Z-Spannung zur Lieferung der zweiten Gleichspannung; und eine Einrichtung (38-42) zur Vorspannung der Z-Diode derart, daß die Diode in ihrem Sperrdurchbruchsbereich arbeitet, wobei die Diode an den Ausgang des Verstärkers (32) zur Lieferung einer alternativen Spannung im wesentlichen gleich der Ausgangsspannung des Verstärkers vermindert um die Z-Spannung angeschlossen ist.

23. Schaltung nach Anspruch 22, bei der die Spannungsteilereinrichtung einen ersten festen Widerstand (38), einen veränderbaren Widerstand (42) und einen zweiten festen Widerstand (40) aufweist, die in Reihe geschaltet sind, wobei ein Verbindungspunkt zwischen dem ersten festen Widerstand und dem veränderbaren Widerstand den H Verbindungspunkt bildet und ein Verbindungspunkt zwischen dem zweiten festen Widerstand und den veränderbaren Widerstand den L Verbindungspunkt bildet und die anderen Enden der beiden festen Widerstände (38, 40) mit der Kathode bzw. Anode der Diode (34) verbunden sind derart, daß einer der beiden Verbindungspunkte H, L das modifizierte Steuersignal auf einem gewünschten Gleichstrompegel für den Transistor liefert.

24. Schaltung nach Anspruch 23, bei der der erste und der zweite Widerstand (38, 40) im wesentlichen denselben Widerstandswert aufweisen.

25. Schaltung nach den beiden Ansprüchen 17 und 24, bei der die Einrichtung (14) zum Anlegen der halben Drain-Source-Spannung umfaßt: eine Einrichtung (44, 46) zum Anschluß des Gate des Transistors entweder an den H oder an den L Verbindungspunkt, einen dritten und einen vierten Widerstand (52, 54) im wesentlichen desselben Werts, die in Reihe zwischen den H und den L Verbindungspunkt geschaltet sind; und eine Einrichtung (60) zum Anlegen eines Vielfachen der Drain-Source-Spannung des Transistors an den Verbindungspunkt zwischen dem dritten und dem vierten Widerstand, wobei der Wert des dritten und des vierten Widerstands zum Wert des ersten und des zweiten Widerstands in einem solchen Verhältnis steht, daß die halbe Drain-Source-Spannung des Transistors an das Gate des Transistors angelegt wird.

26. Verfahren zur Steuerung eines veränderbaren Widerstands, dessen Leitwert eine vorbestimmte Funktion eines Steuersignals $V_C$ der Form $F(c(V_C - V_T))$ ist, wobei c und $V_T$ gewünschte Konstanten und F eine ausgewählte Funktion sind und das Verfahren die Schritte umfaßt: Vorsehen eines Feldeffekttransistors, dessen Drain-Source-Leitwert im wesentlichen eine Funktion $F(a(V_{GS} - V_P))$ seiner Gate-Source-Spannung $V_{GS}$ ist, wobei die Konstanten a und $V_P$ verschieden sind von den gewünschten Konstanten c bzw. $V_T$; Modifizieren des Steuersignals durch Multiplizieren des Steuersignals mit einem Faktor und Hinzuaddieren eines Offsets und Anlegen des modifizierten Steuersignals an das Gate des Transistors, wobei der Faktor und der Offset derart sind, daß der Drain-Source-Leitwert des Transistors im wesentlichen die vorbestimmte Funktion des empfangenen Steuersignals ist.

## Revendications

1. Circuit pour l'obtention d'une résistance variable dont la conductance est une fonction prédéterminée d'un signal de commande reçu $V_C$ de la forme : $F[c(V_C - V_T)]$ où c et $V_T$ sont des constantes désirées et F est une fonction choisie, le circuit comprenant un transistor à effet de champs (12) dont la conductance drain-source est pratiquement une fonction de la forme : $F[a(V_{GS} - V_P)]$ de sa tension gâchette-source $V_{GS}$, les constantes a et $V_P$ étant différentes des constantes désirées respectives c et $V_T$, une entrée de signal commandée (D) raccordée à l'accès drain-source du transistor et un moyen (10) pour fournir un signal de commande modifié par multiplication du signal de commande reçu par un facteur et par addition à une tension de décalage, le signal de commande modifié étant ainsi appliqué à la gâchette du transistor et le facteur et le décalage étant tels que la conductance drain-source du transistor est pratiquement la fonction prédéterminée du signal de commande reçu.

2. Circuit d'atténuation d'un signal commandé au moyen d'une résistance variable dont la conductance est une fonction prédéterminée d'un signal de commande reçu $V_C$ de la forme : $F[c(V_C - V_T)]$ où c et $V_T$ sont des constantes désirées et F est une fonction choisie, la résistance étant prévue pour atténuer, de façon commandable, le signal commandé selon la fonction prédéterminée, le circuit comprenant un transistor à effet de champs (12) dont la conductance drain-source est pratiquement une fonction de la forme : $F[a(V_{GS} - V_P)]$ de sa tension gâchette-source $V_{GS}$, les constantes a et $V_P$ étant différentes des constantes désirées respectives c et $V_T$, et le signal commandé étant appliqué entre le drain et la source du transistor et un moyen (10) pour fournir un signal de commande modifié par multiplication du signal de commande reçu par un facteur et par addition à une tension de décalage, le signal de commande modifié étant ainsi appliqué à la gâchette du transistor et le facteur et le décalage étant tels que la conductance drain-source du transistor est pratiquement la fonction prédéterminée du signal de commande reçu de façon à ce que le signal commandé soit atténué, de façon commandable, par le transistor selon la fonction prédéterminée.

3. Circuit selon la revendication 2, comprenant de plus un accès entre une entrée du signal commandé (102) et une sortie du signal commandé (104), l'accès comprenant un moyen d'impédance (106), le drain (D) du transistor à effet de champs étant raccordé à l'accès de telle façon que le raccordement drain-source du transistor dérive l'accès de façon à ce que le transistor et le moyen d'impédance fournissent une caractéristique désirée d'atténuation à un signal appliqué à l'entrée du signal commandé.

4. Circuit selon la revendication 3, comprenant de plus un moyen (116) de génération du signal de commande $V_C$ à partir de la sortie du circuit afin de commander l'atténuation d'un signal à l'entrée du signal commandé, le moyen de génération du signal de commande (116) et le moyen de génération du signal de commande modifié (10) formant un circuit de rétroaction de la sortie du signal commandé (104) à la gâchette (G) du transistor.

5. Circuit selon la revendication 4, comprenant de plus un filtre à bande fixe (160) raccordé, afin de filtrer des signaux d'entrée, au moyen d'impédance (106).

6. Circuit selon la revendication 4, comprenant de plus un filtre à bande fixe (106) monté entre la sortie (104) et le drain du transistor (152) afin de filtrer les signaux de sortie du transistor.

7. Circuit selon la revendication 5 ou 6, dans lequel le filtre à bande fixe est un filtre passe-bande.

8. Circuit selon la revendication 5 ou 6, dans lequel le filtre à bande fixe est un filtre passe-haut.

9. Circuit selon la revendication 5 ou 6, dans lequel le filtre à bande fixe est un filtre passe-bas.

10. Circuit selon l'une quelconque des revendications 3 à 9, dans lequel le moyen d'impédance est une résistance, le circuit agissant comme un filtre à bande fixe.

11. Circuit selon l'une quelconque des revendications 3 à 9, dans lequel le moyen d'impédance est un condensateur, le circuit agissant comme un filtre passehaut à bande mobile.

12. Circuit selon l'une quelconque des revendications 3 à 9, dans lequel le moyen d'impédance comprend un moyen d'inducteur, le circuit agissant comme un filtre passe-bas à bande mobile.

13. Circuit selon l'une quelconque des revendications 3 à 12, comprenant de plus un accès principal du signal (162; 166; 162'; 166') qui est pratiquement linéaire par rapport à la gamme dynamique et un moyen (164; 170; 164'; 170') pour la combinaison des sorties de l'accès principal du signal et de l'accès (150) contenant le moyen d'impédance (106), l'entrée de l'accès contenant le moyen d'impédance étant couplée à l'entrée ou à la sortie de l'accès principal.

14. Circuit selon l'une quelconque des revendications précédentes, dans lequel la fonction prédéterminée est de la forme suivante :

$$G = c(V_C - V_T)$$

où G est la conductance désirée.

15. Circuit selon la revendication 14, dans lequel la conductance drain-source du transistor à effet de champs est de la forme suivante :

$$G_{DS} = a(V_{GS} - V_P)$$

où $G_{DS}$ est la conductance drain-source du transistor et $V_P$ est la tension de pincement du transistor.

16. Circuit selon la revendication 15, dans lequel le moyen (10) pour fournir un signal de commande modifié comprend un moyen (18) pour soustraire la constante $V_T$ du signal de commande $V_C$ afin de constituer un signal différentiel, un moyen (20) pour multiplier le signal différentiel par pratiquement le facteur c/a pour produire un signal de produit pratiquement égal à $(c/a)(V_C - V_T)$ et un moyen (16) pour additionner $V_P$ au signal de produit afin de dériver le signal de commande modifié de façon à ce que le signal de commande modifié, lorsqu'il est appliqué à la gâchette du transistor (12), amène la conductance drain-source du transistor à être pratiquement la fonction prédéterminée du signal de commande $V_C$.

17. Circuit selon la revendication 16, comprenant de plus un moyen (14) pour appliquer pratiquement la moitié de la tension drain-source du transistor à la gâchette du transistor afin de réduire la distorsion.

18. Circuit selon la revendication 15, 16 ou 17, dans lequel le moyen de génération du signal de commande modifié (10) comprend un amplificateur (32), le signal de commande étant appliqué à l'entrée non inversée de l'amplificateur, un circuit de rétroaction négative de l'entrée d'inversion de l'amplificateur contenant une résistance réglage $R_1$, une résistance $R_2$ raccordant une alimentation de tension D.C. à l'entrée d'inversion de l'amplificateur, la résistance $R1$ étant réglée de façon à ce que le rapport $(R_1 + R_2)/R_2$ est pratiquement égal à c/a et des moyens (34 à 42) pour additionner une tension de décalage à la sortie de l'amplificateur afin de dériver le signal de commande modifié, ladite tension de décalage étant choisie de façon à ce que le signal de commande modifié, lorsqu'il est appliqué à la gâchette du transistor, amène la conductance drain-source du transistor à être pratiquement la fonction prédéterminée du signal de commande $V_C$.

19. Circuit selon la revendication 18, dans lequel la tension D.C. est pratiquement égale $V_T$ et la tension de décalage est choisie pour être pratiquement égale à $(V_P - V_T)$.

20. Circuit selon la revendication 19, dans lequel la valeur de $V_T$ est établie de façon à ce que pratiquement la tension $V_T$ soit appliquée à la gâchette du transistor afin de simplifier un processus de réglage des valeurs de R1 et de la tension de décalage.

21. Circuit selon la revendication 18, 19 ou 20, dans lequel le moyen d'addition du décalage comprend des moyens de diviseur de tension (38 à 42) pour dériver la tension de décalage d'une seconde tension D.C., le moyen de diviseur possédant un circuit de résistance réglable réglé de façon à ce que le décalage dérivé soit pratiquement $(V_P - V_T)$.

22. Circuit selon la revendication 21, comprenant de plus une diode Zener (34) avec une tension choisie de Zener pour fournir la seconde tension D.C. et des moyens (38 à 42) pour polariser la diode Zener de façon à ce que la diode fonctionne dans sa zone inverse de coupure, la diode étant raccordée à la sortie de l'amplificateur (32) pour fournir une tension alternative pratiquement égale à la tension de sortie de l'amplificateur réduite par la tension Zener.

23. Circuit selon la revendication 22, dans lequel le moyen de diviseur de tension comprend une première résistance fixée (38), une résistance variable (42) et une seconde résistance fixée (40) montées en série, un noeud situé entre la première résistance fixée et la résistance variable définissant le noeud H et un noeud situé entre la seconde résistance fixée et la résistance variable définissant le noeud L, les deux résistances fixées (38, 40) possédant des autres extrémités raccordées à la cathode et à l'anode de la diode (34) de façon à ce que l'un des deux noeuds H, L fournisse le signal de commande modifié à un niveau D.C. désiré pour le transistor.

24. Circuit selon la revendication 23, dans lequel la première et la seconde résistance (38, 40) ont pratiquement la même valeur.

25. Circuit selon les revendications 17 et 24, dans lequel le moyen (14) d'application de la moitié de la tension drain-source comprend des moyens (44, 46) de raccordement de la gâchette du transistor soit au noeud H soit au noeud L, une troisième et une quatrième résistances (52, 54) ayant pratiquement la même valeur et étant montées en série entre les noeuds H et L et un moyen (60) pour appliquer un multiple de la tension drain-source du transistor à la jonction entre les troisième et quatrième résistances, la valeur des troisième et quatrième résistances subissant un rapport de la valeur des première et seconde résistances tel que la moitié de la tension drain-source du transistor soit appliquée à la gâchette du transistor.

26. Procédé de commande d'une résistance variable dont la conductance est une fonction prédéterminée d'un signal de commande $V_C$ de la forme : $F[c(V_C - V_T)]$ où $c$ et $V_T$ sont des constantes désirées et $F$ est une fonction choisie, le procédé comprenant une étape de prévision d'un transistor à effet de champs dont la conductance drain-source est pratiquement une fonction de la forme : $F[a(V_{GS} - V_P)]$ de sa tension gâchette-source $V_{GS}$, les constantes $a$ et $V_P$ étant différentes des constantes désirées respectives $c$ et $V_T$, une étape de modification du signal de commande par multiplication du signal de commande par un facteur et par addition d'une tension de décalage et une étape d'application du signal de commande modifié à la gâchette du transistor, le facteur et la tension de décalage étant tels que la conductance drain-source du transistor est pratiquement la fonction prédéterminée du signal de commande reçu.

FIG.1A.

FIG.2A.

FIG.1B.

FIG.2B.

FIG.1C.

FIG.2C.

FIG.3A.

SLOPE C

$G$

$V_T$        $V_C$

FIG.3B.

SLOPE $a$

$G_{DS}$

$V_P$        $V_{GS}$

10

$$V_{GS} = \frac{c}{a}(V_C - V_T) + V_P$$

$V_C$

D

12

S

FIG.4.

10

$$V_{GS} = \frac{c}{a}(V_C - V_T) + V_P$$

$V_C$

$\frac{1}{2}$   14

16

D

12

S

FIG.5.

10

18   20   16

$V_C$   +   $V_T$   $\frac{c}{a}$   +   $V_P$

$\frac{1}{2}$   14

D   12

S

FIG.6.

18

FIG. 7.

FIG. 8.

FIG. 9.

FIG. 10.

$$V_{GS} = \frac{c}{a}(V_C - V_T) + V_P$$